# EUROPÄISCHE PATENTSCHRIFT

(11) **EP 0 788 727 B1**
(45) Veröffentlichungstag und Bekanntmachung des Hinweises auf die Patenterteilung: **25.11.1998**
(21) Anmeldenummer: 95935817.7
(22) Anmeldetag: 18.10.1995
(51) Int. Cl.: H05K 3/00, H05K 3/14, H05K 3/42

(54) **VERFAHREN ZUR HERSTELLUNG ELEKTRISCHER SCHALTUNGSTRÄGER**
PROCESS FOR MANUFACTURING ELECTRICAL CIRCUIT BASES
PROCEDE DE FABRICATION DE SUPPORTS DE CIRCUITS ELECTRIQUES

(30) Priorität: 18.10.1994 DE 4438777
(43) Veröffentlichungstag der Anmeldung: 13.08.1997
(73) Patentinhaber: ATOTECH Deutschland GmbH, 10553 Berlin (DE)
(72) Erfinder: MEYER, Heinrich, D-14109 Berlin (DE)
(74) Vertreter: Effert, Bressel und Kollegen
(86) Internationale Anmeldenummer: DE9501500
(87) Internationale Veröffentlichungsnummer: WO9612392

(56) Entgegenhaltungen:
- EP-A- 0 321 734
- EP-A- 0 329 845
- WO-A-92/15408
- WO-A-93/26143
- US-A- 5 158 645
- HYBRID CIRCUIT TECHNOLOGY, Oktober 1990 Seiten 21-26, G. LEHMAN-LAMER ET AL. 'New Multilayer Polyimide Technology teams with Multilayer Ceramics to form MultiChip Modules' in der Anmeldung erwähnt

## Beschreibung

Die Erfindung betrifft ein Verfahren zur Herstellung elektrischer Schaltungsträger.

Die auf elektrischen Schaltungsträgern, beispielsweise auf Leiterplatten, befindlichen Leiterzüge werden im allgemeinen durch eine Kombination von Ätzprozessen und elektrolytischen Abscheidungsverfahren aus mit Kupferfolien belegten Schichtlaminaten hergestellt. Die Verfahrenstechniken, die hierbei eingesetzt werden, sind in der Literatur vielfach beschrieben worden (beispielsweise Handbuch der Leiterplattentechnik, Hrsg. G. Herrmann, Band 2, Eugen G. Leuze-Verlag, Saulgau, 1991).

Meist wird die Pattern-Plating-Technik eingesetzt, bei der die Leiterzüge und die Kupferschichten in den Löchern durch elektrolytische Kupferabscheidung in Kanälen in einem strukturierten Resist und anschließendes Entfernen der nicht die Leiterzüge bildenden Kupferbereiche durch Ätzen erzeugt werden.

Bei der Panel-Plating-Technik wird zunächst eine dicke Kupferschicht flächig auf die Laminatoberflächen und die Lochwände abgeschieden. Anschließend werden die Leiterzüge durch einen Ätzprozess aus der Kupferschicht gebildet. Auch eine Kombination der Pattern-Plating-Technik mit der Panel-Plating-Technik ist möglich.

Derartige Verfahren sind zur Herstellung von Leiterplatten zwar geeignet, jedoch liegt die Breite der feinsten mit derartigen Techniken reproduzierbar herstellbaren Leiterzüge im Bereich von etwa 100 µm.

Im Falle der Polyimid-Laminate als Trägermaterialien für elektrische Schaltungsträger besteht zudem noch der Nachteil, daß die Kupferfolien in herkömmlicher Weise durch Verkleben mit den Polyimidoberflächen verbunden werden. Jedoch erweicht die Kleberschicht bei thermischer Behandlung und ist auch gegenüber den chemischen Bädern, die für die Lochmetallisierung in den Polyimid-Laminaten eingesetzt werden, nicht ausreichend beständig.

Um die Kleberschichten zu vermeiden, wurde die dem Fachmann geläufige "Cast-on"-Technik zur Herstellung kleberfreier Polyimid-Laminate entwickelt, bei der flüssige Polyamidsäure-Lösung vor der Dehydratisierung und Cyclisierung zum Polyimid auf eine Kupferfolie aufgegossen wird, so daß nach der Bildung des Polyimids auf der Kupferfolie ein haftfester Polymer/Metall-Verbund entstehen kann.

Jedoch hat dieses Verfahren den Nachteil, daß nur relativ dicke, beispielsweise 17 µm dicke, Kupferfolien verwendet werden können, so daß feinste Leiterzugstrukturen aus diesen Materialien nicht herstellbar sind.

Mit dünnen Kupferfolien beschichtete Materialien wurden zwar hergestellt. Jedoch ist der Aufwand zur Herstellung dieser Materialien außerordentlich hoch, so daß deren Materialkosten auch beträchtlich sind. Außerdem ist die Handhabung dieser Materialien problematisch. Im Falle der "cast-on"-Technik zur Herstellung von Polyimid-Schaltungsträgern können derartig dünne Folien überhaupt nicht eingesetzt werden, da sich das Material bei der Herstellung stark verwerfen würde.

Feinere Leiterzüge sind allenfalls dadurch erzeugbar, daß keine mit Kupferfolien an der Oberfläche versehenen Schichtlaminate als Ausgangsmaterialien verwendet werden. Die Leiterzüge werden in diesem Fall durch Metallabscheidung direkt auf den Laminatoberflächen und anschließende Strukturierung mit Photoresisten gebildet.

Aus den vorgenannten Gründen wurden andere Verfahren zur haftfesten Metallisierung von Laminaten, beispielsweise aus Epoxidharzen und Polyimiden, entwickelt. Hinsichtlich der Anforderung, eine ausreichende Haftfestigkeit der abgeschiedenen Metallschichten, auch während und nach einer thermischen Beanspruchung der Materialien zu erreichen, und der zusätzlichen Anforderung, daß die Laminatoberflächen beim Metallisierungsprozess nicht übermäßig aufgerauht werden, stellt die Metallabscheidung durch Zersetzen flüchtiger Metallverbindungen mittels Glimmentladung eine überlegene Verfahrensweise dar. Bei der Metallisierung soll die mittlere Rautiefe der Laminatoberflächen nicht größer als 7 µm sein.

In DE-P 35 10 982 A1 wird ein solches Verfahren zur Herstellung elektrisch leitender Strukturen auf Nichtleitern durch Abscheidung metallischer Filme auf den Nichtleiteroberflächen durch Zersetzung metallorganischer Verbindungen in einer Glimmentladungszone offenbart. Die abgeschiedenen Metallfilme dienen vorzugsweise als katalytisch aktive Keimschichten zur nachfolgenden stromlosen Metallisierung der Oberflächen.

In DE-P 37 16 235 A1 wird ein Verfahren zum Herstellen von elektrisch leitfähigen Polymer-Metallverbindungen auf anorganischen oder organischen Substraten beschrieben. Auch bei diesem Verfahren werden in einer Glimmentladungszone gasförmige metallorganische Verbindungen zersetzt, wobei zusätzlich gasförmige organische Verbindungen, wie beispielsweise Ethen, Propen oder Acrylnitril, polymerisiert werden, so daß sich aus beiden Bestandteilen eine leitfähige Polymer-Metallverbindung bildet.

In DE-P 37 44 062 A1 wird ein Verfahren zur Herstellung metallischer Strukturen auf Fluorpolymeren oder thermoplastischen Kunststoffen durch Zersetzung metallorganischer Verbindungen in einer Glimmentladung beschrieben.

In DE-P 38 06 587 A1 wird ein Verfahren zur Herstellung metallischer Strukturen auf Polyimid durch Zersetzung metallorganischer Verbindungen in einer Glimmentladung beschrieben.

Mit diesen Verfahren ist es möglich, haftfeste Metallschichten auf Nichtleitern, beispielsweise Laminaten, zu erzeugen, um daraus durch Strukturierung mit Photoresisten feinste Leiterzüge zu bilden. Zur Herstellung hochverdichteter Schaltungen werden neben den feinsten Leiterzügen jedoch auch feinste Löcher benötigt.

Es hat sich herausgestellt, daß nach herkömmlichen Methoden hergestellte Löcher zur Verbindung verschiedener Leitungsebenen zu aufwendig ist, da die Löcher nacheinander gebohrt werden, und die bekannten Verfahren zur Erzeugung der erforderlichen feinsten Löcher mit Durchmessern unter 100 µm nicht geeignet sind. Derartige Löcher können durch Ätzprozesse hergestellt werden, wenn hierzu geeignete Ätzmasken bereitstehen, mit denen die Bereiche auf der Laminatoberfläche abgedeckt werden, die während des Ätzprozesses nicht angegriffen werden sollen.

In US-PS 32 65 546 wird ein Verfahren zum chemischen Ätzen von Löchern in einer elektrischen Leiterplatte beschrieben, bei dem zunächst auf chemischem Wege Löcher in die Kupferfolien auf den Außenseiten des Leiterplatten-Laminats geätzt und anschließend in einem weiteren chemischen Ätzschritt in den freien Kupferfolien-Bereichen Löcher in dem Laminat selbst erzeugt werden.

In der DE-OS 20 59 425 wird ein derartiges Verfahren zum partiellen Aufbauen von gedruckten Mehrlagenschaltungen offenbart, bei dem mit Metallfolien versehene Isolierstoffolien, vorzugsweise glasfaserverstärkte Epoxidharzfolien, mit einer ätzresistenten Abdeckung beschichtet werden, in den Bereichen der späteren Löcher die Abdeckung entfernt wird und durch einen vorzugsweise chemischen Ätzprozess zunächst die Löcher in den Metallfolien und anschließend in den Isolierstoffolien selbst erzeugt werden. Die Metallfolien bleiben während des anschließenden Metallisierungsprozesses der Löcher auf den Isolierstoffolien.

In US-PS 48 89 585 wird ein Verfahren zum Bilden von Löchern vorbestimmter Größe und Form in einem Polyimid/Polyamid-Substrat beschrieben, wobei das Substrat auf mindestens einer Seite eine festhaftende Metallschicht aufweist. Zur Bildung der Löcher werden zuerst die Löcher durch geeignete Ätzmittel in der Metallschicht und danach mit heißer konzentrierter Schwefelsäure in dem Substrat gebildet.

In EP 0 168 509 A1 wird ebenfalls ein Verfahren zum Herstellen eines Musters in glasfaserverstärkten Kunststoffplatten, vorzugsweise aus Epoxidharz, beschrieben, wobei wie in den vorangegangenen Beispielen eine Kunststoffplatte zunächst mit einer Kupferfolie, in diesem Fall mit einer Dicke von beispielsweise 5 µm, und einer Photolackfolie versehen wird und beide (Kupfer- und Photolackfolie) anschließend an den für die Löcher vorgesehenen Stellen weggeätzt werden. Danach wird das Harz der Kunststoffplatte in einem Trockenätzverfahren mittels Plasmatechnik entfernt, wobei die Glasfasern in der Platte nicht entfernt werden und dadurch in das Loch hineinragen. Diese werden zusammen mit den Lochwänden in einem nachfolgenden Verfahrensschritt metallisiert. Dadurch werden jedoch insbesondere feinste Löcher verstopft, so daß die nachfolgende Metallisierung in den Löchern nicht ausreichend sicher durchgeführt werden kann, ohne daß sich beispielsweise Gaseinschlüsse innerhalb der Löcher bilden. Die Kupferfolie bleibt bei der Metallisierung der Löcher auf der Kunststoffplattenoberfläche.

In EP 0 283 546 A1 wird ein Verfahren zum Herstellen beliebig geformter mikromechanischer Bauteile aus planparallelen Platten aus polymerem Substratmaterial oder beliebig geformter Durchführungsöffnungen in diesen Platten beschrieben. Hierzu wird zunächst eine Ätzmaske aus einem organischen Polymeren, das vorzugsweise mittels cyclischer Organosiliziumverbindungen behandelt wird, auf die Substratoberfläche aufgebracht, diese anschließend photostrukturiert und entwickelt. Die Löcher im Substrat werden mittels eines reaktiven lonenätzverfahrens an den Stellen der Löcher in der Ätzmaske hergestellt. Die Ätzmaske wird nach dem Erzeugen der Löcher von der Substratoberfläche wieder entfernt. Es wird angegeben, daß die nachfolgende Entfernung des Photoresists beträchtliche Probleme bereitet.

In der WO 92/15408 wird ein Verfahren zur Herstellung von Leiterplatten aus dünnen Folien offenbart. Hierzu wird zunächst eine mit Metallschichten versehene Kunststoffolie mit einer Photoresistschicht versehen, diese nach üblichen Verfahren strukturiert, anschließend die Löcher in einem naßchemischen oder Plasmaätzverfahren im Substrat gebildet und schließlich die Photoresistschicht und die Metallschicht von der Substratoberfläche wieder entfernt. Fakultativ wird angegeben, für unbeschichtete Folien auch eine Photoresistschicht oder eine Metallschicht auf das Substrat aufzubringen. Die Schicht wird in diesem Fall als Ätzresistschicht für den Lochbildungsprozess verwendet. Zur Bildung von Leiterzügen sollen übliche naßchemische Aktivierungs- und Metallisierungsverfahren eingesetzt werden. Metallschichten von 7 - 12 µm Dicke sollen dabei auflaminiert oder durch Sputtern erzeugt werden.

In dem Aufsatz "New multilayer polyimide technology teams with multilayer ceramics to form multichip modules" von G. Lehman-Lamer et al., Hybrid Circuit Technology, October 1990, Seiten 21 - 26, wird ein Verfahren zur Erzeugung von Polyimid-Multilayern aus Keramik und Polyimid für Multichip-Module beschrieben. In diesem Fall handelt es sich jedoch um aus Lösungen auf feste Unterlagen aufgegossene und durch schnelle Drehung der Unterlagen zu dünnen Schichten ausgebreitete sogenannte "Spin-coatings" aus Polyimid. Diese werden zuerst mit einer aufgedampften Metallschicht belegt. An den Stellen späterer Löcher wird die Metallschicht mittels Photoresist und anschließendem Ätzprozess perforiert und die exponierte Polyimidschicht in einem Verfahren zum reaktiven lonenätzen selektiv entfernt. Danach wird das Metall wieder entfernt und eine Metallschicht auf die gesamte Polyimidoberfläche aufgedampft. Zur Erzeugung der Leiterzüge wird auf diese Schicht anschließend ein weiterer Photoresist aufgebracht, belichtet, entwickelt und danach beispielsweise Gold auf der ersten Metallschicht elektrolytisch abgeschieden. Da die erste Metallschicht zur Bildung der Leiterzüge auf die Polyimidoberflächen aufgedampft wird, haften diese nicht ausreichend auf der Unterlage.

Nachteilig an derartigen Verfahren zur Herstellung von Multichip-Modulen ist auch, daß die Herstellung der Polyimidschichten durch die spin-coating-Technik sehr aufwendig ist, nur kleine Formate und diese auch nur im Einfachnutzen hergestellt werden können. Daher ist die Technik sehr teuer.

Die vorstehend beschriebenen Verfahren sind jedoch nicht geeignet, Laminate, die auch aus mehreren Laminatschichten bestehen können, mit einer haftfesten Metallschicht zur Erzeugung feinster Leiterzugstrukturen (Strukturbreiten unter 100 µm) und feinster Löcher (Durchmesser unter 100 µm) zu versehen. Mit den bekannten Verfahren können entweder nur relativ breite Leiterzüge erzeugt werden, bei denen die Anforderungen an die Haftfestigkeit auf der Laminatoberfläche wegen der größeren Auflagefläche geringer sind, oder es können keine hochverdichteten Schaltungen mit feinsten Bohrungen hergestellt werden. Meist werden in den bekannten Verfahren Laminate mit relativ dicken Metallfolien an den Außenseiten verwendet, die auf die Laminatoberflächen, beispielsweise durch Verpressen, aufgebracht werden. In diesem Fall ist es nicht möglich, feinste Leiterzüge zu erzeugen.

Der vorliegenden Erfindung lag von daher das Problem zugrunde, die vorstehend genannten Nachteile des Standes der Technik zu vermeiden und ein Verfahren zur Herstellung elektrischer Schaltungsträger aus ein- oder mehrlagigen Laminaten mit haftfest und nicht wieder lösbaren Leiterzügen auf den Laminatoberflächen mit Leiterzugbreiten und -abständen unter 100 µm und metallisierten Löchern in den Laminaten mit Durchmessern unter 100 µm zu finden.

Das Problem wird gelöst durch ein Verfahren gemäß Anspruch 1. Bevorzugte Ausführungsformen sind in den Unteransprüchen angegeben.

Die elektrischen Schaltungsträger werden gemäß dem folgenden prinzipiellen Verfahrensablauf aus den Laminaten hergestellt:
- Einbringen von Löchern mit Durchmessern unter 100 µm in die Laminate durch
   - Aufbringen einer Metallschicht auf mindestens eine Laminatoberfläche,
   - Strukturieren der Metallschicht mit einer Photomaskentechnik durch folgende Verfahrensschritte:
      - Belegen der Metallschicht mit einem Photolack,
      - Belichten und Entwickeln der Photomaske, wobei die Photomaske beim Entwickeln in den Bereichen entfernt wird, in denen Löcher im Laminat vorgesehen sind,
      - gegebenenfalls Entfernen der Photomaske,
- Ätzen der Löcher im Laminat, vorzugsweise mit einem Vakuumätzverfahren, und
- Entfernen der Metallschicht und noch vorhandener Teile der Photomaske,
- Bilden von Leiterzugstrukturen mit Strukturbreiten und -abständen von unter 100 µm auf mindestens einer Laminatoberfläche und Metallisieren der Lochwände durch
   - Abscheiden einer haftfesten und nicht wieder lösbaren ersten oder Grund-Metallschicht auf den Laminatoberflächen und den Lochwänden durch Zersetzen flüchtiger Metallverbindungen mittels Glimmentladung,
   - Abscheiden weiterer Metallschichten auf der Grund-Metallschicht durch stromlose und/oder elektrolytische Metallisierung und
   - Strukturieren einzelner Metallschichten mittels Photomaskentechnik.

Mit dem erfindungsgemäßen Verfahren können feinste Löcher mit Durchmessern unter 100 µm im Laminat hergestellt und anschließend metallisiert werden. Dadurch wird eine sehr hohe Verdrahtungsdichte in den Schaltungen ermöglicht.

Die Metallschicht, die zur Herstellung der Ätzmaske (Lochmaske) für die Erzeugung der Löcher auf die Laminatoberflächen aufgebracht wird, wird nur temporär auf die Laminatoberflächen aufgebracht, d.h. vor dem Erzeugen der Leiterzüge vom Laminat wird sie wieder entfernt und dient nicht als Grund-Metallschicht für die Bildung der Leiterzüge. Daher kann sich eine mögliche Beeinträchtigung des Verbundes zwischen der Ätzmaske und der Laminatoberfläche beim Ätzen der Löcher nicht nachteilig auf die Haftfestigkeit der später erzeugten Leiterzüge auswirken.

Erst durch die Kombination der erfindungsgemäßen Verfahrensvarianten zur Locherzeugung und zur Erzeugung der Leiterzugstrukturen können feinste Leiterzüge und Löcher gebildet werden, so daß hochverdichtete Schaltungsträger entstehen. Dadurch daß Laminate ohne Kupferbeschichtung verwendet werden, vorzugsweise Folien oder mit organischen Polymerfasern verstärkte Dünnlaminate, können die Schaltungsträger sehr kostengünstig und einfach hergestellt werden.

Das Verfahren kommt mit relativ einfachen und billigen Ausgangsstoffen aus. Beispielsweise können Laminate ohne Metallschichten auf den Oberflächen als Trägersubstrate verwendet werden.

Da keine mit Kupferfolien versehene Laminate verwendet werden, ist der direkte Metallaufbau durch Anwendung der Metallisierung mittels einer im Prinzip beliebigen Glimmentladung möglich, so daß feinste Leiterzugstrukturen unter 100 µm Breite herstellbar sind.

Durch Zersetzen flüchtiger Metallverbindungen mittels Glimmentladung für die Leitschichterzeugung wird ein sehr haftfester und nicht wieder lösbarer Verbund zwischen den Leiterzugstrukturen und der Laminatoberfläche erreicht, so daß auch von daher feinste Leiterzüge hergestellt werden können. Ferner bleibt die Haftfestigkeit auch noch während der und nach den üblichen thermischen Behandlungen, wie beispielsweise dem Löten, erhalten.

Bei der Herstellung feinster Leiterzüge werden besondere Anforderungen an die Haftfestigkeit der Leiterzüge auf der Laminatoberfläche gestellt. Dies liegt daran, daß nur durch eine äußerst geringe Auflagefläche der Leiterzüge eine ausreichende Haftfestigkeit zur Laminatoberfläche erreicht werden kann. Die Behandlung mit korrosiven Lösungen oder gasförmigen Stoffen, die diesen Verbund von der Seite her angreifen, kann sehr schnell dazu führen, daß sich die unterseitigen Ränder der Leiterzüge keilförmig von der Laminatoberfläche abheben. Im Gegensatz zu breiten Leiterzügen wirken sich derartige keilförmige Delaminationen daher auf die Haftfestigkeit feiner Leiterzüge insgesamt stärker aus als bei breiten Leiterzügen.

Durch das Metallisierungsverfahren in der Glimmentladung ist es wegen der erreichbaren Haftfestigkeitswerte ferner möglich, Laminate aus unterschiedlichen Materialien als Trägersubstrate zu verwenden. Durch den Einsatz von Materialien mit einer niedrigen Dielektrizitätskonstante können kürzere Signallaufzeiten in den elektrischen Schaltungen erreicht werden.

Die zur Erzeugung der Löcher gebildeten Lochmasken auf den Laminatoberflächen werden auf photochemischem Wege mit Photomasken erzeugt. Durch bevorzugte Verwendung eines positiven Photolackes als Photomaske werden eine wesentlich höhere optische Auflösung und damit feinere Strukturen erreicht, da mit einem Photolack dünnere Schichten herstellbar sind (5 - 10 µm Dicke) als beispielsweise mit Trockenfilmen (30 - 50 µm Dicke der Photoresistschichten), so daß das beim Belichten in die Schicht einfallende Licht weniger gestreut wird. Wegen der geringeren Dicke insbesondere von flüssigen Photolackschichten haftet diese auch besser auf der Unterlage. Durch Anwendung positiver Resiste kann ferner eine positive Bildvorlage bei der Belichtung der Resistschicht verwendet werden, so daß sich Belichtungsfehler weniger stark auswirken. Es können auch elektrophoretisch abscheidbare Resiste verwendet werden.

Die Löcher werden anschließend vorzugsweise in einem Vakuum oder Plasmaätzverfahren gebildet. Technisch günstig hat sich auch hier ein Ätzverfahren mittels Glimmentladung oder ein Laserbohrverfahren erwiesen.

Nach der Locherzeugung in der temporären Metallschicht und im Laminat werden die Lochwände und Laminatoberflächen zur Erzeugung einer haftfesten und nicht wieder lösbaren Grundmetallschicht vorzugsweise mittels Glimmentladung vorbehandelt. Beispielsweise werden die Oberflächen geätzt, gereinigt und/oder mit reaktiven Gruppen funktionalisiert, indem Gase mit den chemischen Gruppen an der Oberfläche reagieren.

Zur Strukturierung der Metallschicht bei der Leiterbilderzeugung wird ebenfalls eine Photomaske verwendet. In einer besonders vorteilhaften Ausführungsform wird wie zur Herstellung der Lochmasken auch in diesem Fall eine positive Photolackschicht verwendet. Es kann auch ein elektrophoretisch abscheidbarer Resist eingesetzt werden.

Um zu vermeiden, daß der Verbund zwischen der Grund-Metallschicht und der Laminatoberfläche beeinträchtigt wird, wird zur weiteren Metallisierung der Laminate ein Metall aus einem vorzugsweise sauren oder neutralen stromlosen oder elektrolytischen Metallisierungsbad auf der Grund-Metallschicht abgeschieden. Alkalische Bäder, wie beispielsweise stromlose Kupferbäder mit Formaldehyd als Reduktionsmittel, verringern die Haftfestigkeit der Grund-Metallschicht zur Laminatoberfläche oder lösen diesen Verbund sogar auf.

Als nächste Metallschicht auf der Grund-Metallschicht eignet sich insbesondere eine Nickel/Bor-Legierungsschicht. Alternativ hierzu kann auch eine Kupferschicht aus einem sauren oder neutralen stromlosen Kupferbad mit Hypophosphit als Reduktionsmittel auf der Grund-Metallschicht abgeschieden werden.

Sowohl die Nickel/Bor-Legierungs- als auch die Kupferschicht haben überdies den Vorteil, daß sie gegebenenfalls beim Strukturieren der Leiterzugstrukturen von der Grund-Metallschicht leicht wieder abgeätzt werden können.

Aus sauren oder neutralen stromlosen Palladiumbädern abgeschiedene Palladiumschichten bieten zwar den Vorteil, daß der Haftverbund zwischen der Grund-Metallschicht und der Laminatoberfläche bei der Metallabscheidung nicht angegriffen wird. Jedoch ist Palladium nur schwierig ätzbar und kann daher nur in den Fällen auf die Grund-Metallschicht abgeschieden werden, in denen diese Metallschicht in weiteren Verfahrensschritten nicht mehr durch Ätzen entfernt werden muß.

Die Leiterzugstrukturen und Metallschichten in den Löchern werden allerdings in den Bereichen, in denen diese nicht durch Ätzen entfernt werden müssen, im wesentlichen durch stromlose Palladiumabscheidung gebildet, da Palladium leicht abscheidbar ist, ausreichende Schichtdicken leicht erhältlich sind und die Leitfähigkeit und die Korrosionsbeständigkeit den Anforderungen für Leiterzugstrukturen entsprechen.

### Exemplarische Ausführungsvarianten:

Als Laminate für die Herstellung der hochverdichteten Schaltungsträger kommen vorzugsweise Folien aus Polyimid, Polyimid/Polyamid, Aramid, aus Fluorpolymeren, Cyanatester oder Epoxidharzen zum Einsatz. Die Folien können ohne Füllstoffe, wie im Falle von Polyimid, oder mit Füllstoffen, wie beispielsweise Papier, Glas- oder Kohlenstoffasern sowie organischen Polymerfasern, verwendet werden. Jedoch sind auch starre Platten einsetzbar. Beispielsweise kommen hierzu Epoxidharz-Platten aus FR4-Material oder keramische Werkstoffe in Betracht.

Als Ausgangsmaterialien können auch bereits zu Mehrlagenschaltungen verarbeitete Laminate ohne Kupferschichten auf den Außenseiten dienen, in denen die Innenlagen durch das erfindungsgemäße Verfahren oder auf herkömmlichem Wege, beispielsweise durch Ätzen, hergestellt wurden.

Vor der Behandlung können die Laminate, beispielsweise in Netzmittel enthaltenden Lösungen, gereinigt werden. Anschließend wird die Lochmaske auf mindestens eine der Laminatoberflächen aufgebracht. Zur Bildung der Löcher im Laminat werden als Lochmasken-Materialien bevorzugt Aluminium oder Kupfer verwendet. Die Metalle werden vorzugsweise in einem Vakuumverfahren, beispielsweise durch Aufdampfen, oder mit einem anderen Verfahren, abgeschieden. Es kann jedoch auch ein anderes Metall aufgedampft oder in einem Sputterprozess oder auf elektrochemischem Wege aufgebracht werden. Aluminium ist billig, und das Aufdampf-Verfahren ist nicht aufwendig. Beispielsweise können die Laminatoberflächen beidseitig in einer geeigneten Aufdampfanlage durch Arbeiten im Durchlaufverfahren von Rolle zu Rolle mit dem Metall bedampft werden.

Es sind lediglich relativ dünne Aluminium- und Kupfer-Schichten erforderlich (10 - 100 nm). Die Anforderungen an die Haftfestigkeit des Aluminiums auf der Laminatoberfläche sind gering; erforderlich ist lediglich eine ausreichend geringe Porosität des aufgedampften Metallfilmes, um den nachfolgenden Ätzangriff auf das darunterliegende Laminatmaterial zu verhindern. Die Ätzmaske darf auch nicht zu dick sein, da zum einen sonst Stofftransportprobleme beim nachfolgenden Ätzen der Löcher auftreten können (An- und Abtransport reaktiver Gase und der Reaktionsprodukte). Zum anderen können - in dicken Metallätzmasken beim Ätzen in der Glimmentladung eventuell auch Wirbelströme entstehen und die Wirksamkeit und die Geschwindigkeit des Ätzprozesses verringern. Ferner darf sich die Metallschicht beim Ätzverfahren zur Herstellung der Lochmaske nicht von der Unterlage ablösen. Mit Lochmasken aus Aluminium- und Kupferschichten entstehen diese Probleme nicht.

Zur Bildung des Lochrasters auf den Laminatoberflächen werden diese anschließend mit einer Photomaske, vorzugsweise mit positivem Photolack, beschichtet. Für niedrige und mittlere Bildauflösung werden beispielsweise Trokkenfilme verwendet und für hohe Bildauflösung vorzugsweise positive flüssige Photolacke. Die Lacke können durch Tauchen des Laminats, elektrostatisches Sprühen, in einem Vorhanggießverfahren oder durch andere Techniken auf die Laminatoberflächen aufgebracht werden.

Durch die anschließende Belichtung der mit der Photomaske beschichteten Oberflächen und nachfolgende Entwicklung in einer geeigneten Entwicklerlösung werden die Bereiche der Metalloberflächen wieder freigelegt, die dem Lochmuster entsprechen. An die Belichtung schließt sich die Entwicklung der Photomaskenschicht an. Beispielsweise wird hierzu ein organisches Lösemittel oder eine wäßrige Natriumcarbonat-Lösung verwendet. Auch eine Mischung des organischen Lösemittels mit Natriumcarbonat kann eingesetzt werden.

Danach werden die freigelegten Metalloberflächen durch einen Ätzprozess entfernt. Die Metallschicht dient im nachfolgenden Ätzprozess als Lochmaske. Zur Entfernung wird beispielsweise eine chemische Ätzlösung verwendet. Im Falle von Aluminium ist eine saure Ätzlösung, die Eisen-(III)-chlorid und gegebenenfalls Wasserstoffperoxid enthält, geeignet. Anschließend wird die Photolackschicht von der Laminatoberfläche wieder entfernt. Wird die Photomaskenschicht vor dem Laminat-Ätzprozeß nicht entfernt, ist der Ätzprozeß zu langsam, da auch die polymere Photomaskenschicht abgeätzt wird und das Plasma der Glimmentladung im wesentlichen bereits durch Reaktion mit der Photomaskenschicht verbraucht wird.

Die Löcher im Laminat werden danach in einem Trockenätz-Verfahren gebildet. Hierzu wird das Laminat mit den darauf befindlichen Lochmasken in einer geeigneten Vorrichtung mit einem Gas, beispielsweise Sauerstoff und gegebenenfalls in Mischung mit Argon und/oder Stickstoff, mittels einer Glimmentladung behandelt.

Wenn das Laminat auf beiden Seiten mit der Photomaske beschichtet wird, sind die Lochmuster auf beiden Seiten so anzuordnen, daß sich die Löcher in der Lochmaske genau gegenüber liegen. In diesem Fall können die Löcher durch die Plasmabehandlung von beiden Seiten gleichzeitig erzeugt werden.

Durch Optimierung der Behandlungsparameter, beispielsweise der Gaszusammensetzung und des Gasdruckes sowie der Glimmentladungsleistung, Behandlungstemperatur und -zeit, entstehen ausreichend steile Lochwände ohne rückgeätzte Hinterschneidungen unter der Lochmaske, so daß sehr feine Löcher auch in dickeren Laminaten gebildet werden können.

Beispiel (Locherzeugung mit Aluminium als Lochmaske, hergestellt mittels Glimmentladung):
1. Aufdampfen oder -sputtern einer Al-Schicht (10 - 100 nm)
2. Beschichten mit Photomaske, Belichten der Photomaske und Entwickeln in 1 %iger Na₂CO₃-Lösung,
3. Löcher in der Al-Schicht chemisch ätzen:
   Ätzlösung: 15 % FeCl₃, 3 % HCl,
   Temperatur: Raumtemperatur,
   Behandlungszeit: 30 Sekunden,
4. Photomaske in Aceton entfernen,
5. Ätzen der Löcher mittels Glimmentladung in einem Plasmaätzgerät (beispielsweise der Fa. Technics Plasma GmbH, Kirchheim, DE),
6. Al-Schicht durch Ätzen entfernen:
   Ätzlösung: 15 % FeCl₃, 3 % HCl,
   Temperatur: Raumtemperatur,
   Behandlungszeit: 30 Sekunden.

Nach der Erzeugung der Löcher im Laminat werden, sofern noch erforderlich, die Photomaskenschicht und anschließend die Lochmaske wieder von der Laminatoberfläche entfernt. An diesen Behandlungsschritt schließt sich die Metallisierung der Laminatoberflächen zur Bildung der Leiterzüge und der Metallschichten an den Lochwänden an.

Zur Erzeugung der Leiterzugstrukturen können die zu beschichtenden Oberflächen zunächst mittels Glimmentladung vorbehandelt werden. Die Behandlungsbedingungen für die Vorbehandlung sind beispielsweise in DE-P 37 44 062 A1 angegeben. Vorzugsweise werden die Oberflächen in Sauerstoff oder in einem Sauerstoff/Argon- oder Sauerstoff/CF4-Gemisch angeätzt.

Die erste Grund-Metallschicht, die auch katalytisch aktiv und haftungsvermittelnd (adhäsionsvermittelnd) wirkt, wird auf die vorbehandelten Oberflächen durch Zersetzen flüchtiger Metallverbindungen aufgebracht. Dabei entsteht eine dünne Metallschicht je nach Beschichtungsbedingungen von 0,01 µm - 1 µm Schichtdicke.

Zur Bildung der Grund-Metallschichten werden insbesondere flüchtige Kupfer-, Palladium-, Gold- oder Platinverbindungen oder deren Mischungen in der Glimmentladung zersetzt. Palladium hat sich als besonders vorteilhaft herausgestellt. Hierbei entstehen für die nachfolgende stromlose Metallabscheidung katalytisch wirkende Metallschichten, so daß eine weitere Aktivierung dieser Metallschichten, beispielsweise mit edelmetallhaltigen Lösungen, meist nicht erforderlich ist.

Als flüchtige Metallverbindungen kommen die in den Druckschriften DE-P 35 10 982 A1, DE-P 37 44 062 A1, DE-P 38 06 587 A1, DE-P 37 16 235 A1 und DE-P 38 28 211 C2 beschriebenen Verbindungen, beispielsweise Kupferhexafluoracetylacetonat, Dimethyl-n-cyclopentadienyl-Platin, Dimethyl-Gold-acetylacetat, 2-Perfluorbuten-2-, 2-Perfluorpropen-1-, Pentafluorphenyl-Silber und insbesondere π-Allyl-π-cyclopentadienyl-Palladium-(II), zum Einsatz. Die dort angegebenen Abscheidungsbedingungen sind auf die Erzeugung der Metallschichten nach dem erfindungsgemäßen Verfahren entsprechend übertragbar.

Für die Metallisierung werden normale Parallelplattenreaktoren verwendet, die als Tunnel- oder Rohrreaktoren ausgebildet sind. Die Glimmentladung kann sowohl mit Gleichstrom als auch mit Wechselstrom (Hochfrequenz im kHz- oder MHz-Bereich) erzeugt werden. Der Druck in der Behandlungskammer beträgt im allgemeinen 0,1 - 50 hPa. Meist wird eine nahe bei Raumtemperatur liegende Temperatur am Laminat durch Variation der elektrischen Leistung der Glimmentladung eingestellt.

Auf diese Grundmetallschicht kann durch stromlose Metallisierung beispielsweise Palladium, eine Nickel/Bor-Legierung oder Kupfer aufgebracht werden. Es kommen hierzu jedoch auch die Metalle Gold und Kobalt oder deren Legierungen sowie Nickel oder andere Legierungen des Nickels in Betracht. Bevorzugt wird diese Schicht aus einer sauren Lösung abgeschieden. Zum volladditiven Metallaufbau wird bevorzugt Palladium stromlos abgeschieden.

Durch weitere stromlose oder elektrolytische Metallabscheidung können auf diese Grund-Metallschichten weitere Metallschichten in der gewünschten Schichtdicke aufgebracht werden. Die Leiterzüge können jedoch auch durch elektrolytische Abscheidung der Metalle Kupfer, Palladium, Gold, Nickel, Kobalt, Zinn oder Blei oder deren Legierungen erzeugt werden.

Zur Erzeugung der Leiterzüge können unterschiedliche Verfahrensalternativen zur Anwendung kommen:

Verfahren 1 ("Lift-Off"-Verfahren):
- Belegen mindestens einer der Laminatoberflächen mit Photomasken,
- Belichten und Entwickeln der Photomasken, wobei die Photomasken beim Entwickeln in den Bereichen entfernt werden, in denen Leiterzugstrukturen vorgesehen sind und in denen sich die Löcher befinden,
- Vorzugsweise Vorbehandeln der Laminatoberflächen und Lochwände mittels Glimmentladung,
- Erzeugen der Grund-Metallschichten auf den Photomasken, in den freiliegenden Bereichen auf den Laminatoberflächen und auf den Lochwänden durch Zersetzen flüchtiger Metallverbindungen mittels Glimmentladung,
- gegebenenfalls dünn stromlos Metall abscheiden,
- Entfernen der Photomasken zusammen mit den darauf abgeschiedenen Metallschichten,
- zum Erzeugen der Leiterzüge und der Metallschichten auf den Lochwänden in den Bereichen auf den Laminatoberflächen, in denen sich die Metallschichten befinden, stromlos Metall, vorzugsweise Palladium, bis zur gewünschten Leiterzugdicke abscheiden.

Der Vorteil dieser Verfahrensweise besteht darin, daß an den Stellen, an denen keine Leiterzüge gebildet werden, lediglich das zur Erzeugung der Lochmaske verwendete Metall aufgebracht und später wieder entfernt wird. Es wird an diesen Stellen jedoch keine für die Leiterzug-Erzeugung verwendete Metallschicht durch Zersetzen der flüchtigen Metallverbindungen in der Glimmentladung abgeschieden. Daher können sich an diesen Stellen keine Metallkontaminationen an der Laminatoberfläche bilden, so daß der Isolationswiderstand zwischen den Leiterzügen besonders hoch ist.

Die Grund-Metallschichten auf den Photomasken-Bereichen werden so dünn gewählt, beispielsweise etwa 0,1 µm, daß deren Entfernung zusammen mit den darunter liegenden Photomasken leicht gelingt, d.h. ohne daß einzelne Stellen der Polymerfilme auf den Laminatoberflächen zurückbleiben. Zur Entfernung der Polymerfilme werden übliche chemische Lösungen verwendet.

Beispiel (Lift-Off-Technik, Substrat Polyimid-Folie, KAPTON® E, DuPont de Nemours, Inc., Wilmington, Del., USA):
1. Beschichten einer perforierten Folie mit flüssigem Photoresist, belichten, entwickeln in 1 %iger Na₂CO₃-Lösung,
2. Vorbehandeln mittels Glimmentladung:
   Gas: Sauerstoff
   Druck: 0,25 hPa,
   Gasfluß: 100 Standard-cm³/min,
   Hochfrequenzleistung: 1000 W,
   Behandlungszeit: 90 Sekunden,
3. Pd-Abscheiden mittels Glimmentladung:
   Metallorganische Verbindung: π-Allyl-π-cyclopentadienyl-Palladium-(II),
   Gas: Ar/O₂ oder N₂/O₂, jeweils in einer Mischung 3 : 1,
   Druck: 0,1 hPa,
   Gasfluß: 25 Standard-cm³/min,
   Verdampfertemperatur: 45 °C,
   Behandlungszeit: 10 - 15 Minuten,
4. Gegebenenfalls stromlos Palladium abscheiden:
   Bad: Pallatech (Fa. Atotech Deutschland GmbH, Berlin, DE),
   Temperatur: 70 °C,
   pH-Wert 6,0,
   Behandlungszeit: 5 - 8 Minuten,
5. Photomaske in Aceton entfernen,
6. Leiterbahnaufbau mit stromloser Palladiumabscheidung wie Verfahrensschritt 4. bis zur gewünschten Schichtdicke.

Verfahren 2 (Volladditiv-Technik):
- Vorzugsweise Vorbehandeln der Laminatoberflächen und Lochwände mittels Glimmentladung,
- Erzeugen der Grund-Metallschichten durch Zersetzen flüchtiger Metallverbindungen mittels Glimmentladung,
- Belegen der Grund-Metallschichten mit Photomasken,
- Belichten und Entwickeln der Photomasken, wobei die Photomasken beim Entwickeln in den Bereichen auf dem Laminat verbleiben, in denen Leiterzugstrukturen vorgesehen sind und sich die Löcher befinden,
- Abätzen der freiliegenden Grund-Metallschicht, vorzugsweise in einer Eisen-(lll)-chlorid- oder verdünnten Salpetersäure/Salzsäure-Lösung,
- Entfernen der Photomasken,
- stromlos Metall, vorzugsweise Palladium, auf den zurückgebliebenen Bereichen der Grund-Metallschicht bis zur gewünschten Schichtdicke abscheiden.

Alternativ zu der letztgenannten Variante werden die Photomasken so belichtet und entwickelt, daß die Photomasken in den Bereichen entfernt werden, in denen Leiterzugstrukturen vorgesehen sind und sich die Löcher befinden. Anschließend wird folgendermaßen verfahren:
- stromlos Metall, vorzugsweise Palladium, und/oder elektrolytisch Metall in den freiliegenden Bereichen auf den Grund-Metallschichten bis zur gewünschten Schichtdicke abscheiden,
- Entfernen der Photomasken und Abätzen der freiliegenden Grund-Metallschichten.

Die Grund-Metallschicht kann durch Differenzätzen leicht wieder entfernt werden, da sie sehr dünn ist.

Beispiel (Volladditiv-Technik mit Palladium-Schicht aus Glimmentladungsabscheidung):
1. Vorbehandeln eines perforierten Substrats in der Glimmentladung:
   Gas: Sauerstoff
   Druck: 0,25 hPa,
   Gasfluß: 100 Standard-cm³/min,
   Hochfrequenzleistung: 1000 W,
   Behandlungszeit: 90 Sekunden,
2. Pd-Abscheiden in der Glimmentladung:
   Metallorganische Verbindung: π-Allyl-π-cyclopentadienyl-Palladium-(II),
   Gas: Ar/O₂ oder N₂/O₂, jeweils in einer Mischung 3 : 1,
   Druck: 0,1 hPa,
   Gasfluß: 25 Standard-cm³/min,
   Verdampfertemperatur: 45 °C,
   Behandlungszeit: 10 - 15 Minuten,
3. Beschichten der Folie mit Trockenfilmresist, belichten, entwickeln in 1 %iger Na₂CO₃-Lösung,
4. Im Resistkanal volladditiv stromlos Palladium abscheiden:
   Bad: Pallatech (Fa. Atotech Deutschland GmbH, Berlin, DE),
   Temperatur: 70 °C,
   pH-Wert 6,0,
   Behandlungszeit: je nach gewünschter Schichtdicke,
5. Trockenfilmresist in Aceton entfernen,
6. Palladium-Differenzätzen mit verdünnter HNO₃/HCl-Lösung.

Falls die Grund-Metallschichten bereits eine ausreichende Leitfähigkeit aufweisen, kann in den Resistkanälen auf elektrolytischem Wege metallisiert werden.

Verfahren 3 (Panel-Plating-Technik):
- Vorzugsweise Vorbehandeln der Laminatoberflächen und Lochwände mittels Glimmentladung,
- Erzeugen der Grund-Metallschichten durch Zersetzen flüchtiger Metallverbindungen mittels Glimmentladung,
- auf den Grund-Metallschichten stromlos Metall abscheiden, vorzugsweise eine Nickel/Bor-Legierungs- oder eine Kupferschicht, abgeschieden aus einem sauren oder neutralen Metallisierungsbad,
- elektrolytisch Metall abscheiden, vorzugsweise Kupfer aus einem sauren Bad,
- Belegen der Metallschichten mit den Photomasken,
- Belichten und Entwickeln der Photomasken, wobei beim Entwickeln die die Leiterzugstrukturen bildenden Bereiche und die Lochwände mit den Photomasken belegt bleiben,
- Abätzen der freiliegenden Metallschichten,
- Entfernen der Photomasken.

Beispiel (Subtraktiv-Technik, Panel-Plating, mit Substrat Polyimid-Folie, KAP-TON H):
1. Vorbehandeln der perforierten Folie mittels Glimmentladung:
   Gas: Sauerstoff
   Druck: 0,25 hPa,
   Gasfluß: 100 Standard-cm³/min,
   Hochfrequenzleistung : 1000 W,
   Behandlungszeit: 90 Sekunden,
2. Pd-Abscheiden mittels Glimmentladung:
   Metallorganische Verbindung: π-Allyl-π-cyclopentadienyl-Palladium-(II),
   Gas: Ar/O₂ oder N₂/O₂, jeweils in einer Mischung 3 : 1,
   Druck: 0,1 hPa,
   Gasfluß: 25 Standard-cm³/min,
   Verdampfertemperatur: 45 °C,
   Behandlungszeit: 10 - 15 Minuten,
3. Stromlos Nickel/Bor aus einem schwach sauren Nickel/Bor-Bad abscheiden (mit Dimethylaminoboran als Reduktionsmittel):
   Temperatur: 40 °C,
   Behandlungszeit: 2 Minuten,
4. Elektrolytisch Kupfer abscheiden:
   Bad: Cupracid BL (Fa. Atotech Deutschland GmbH, Berlin, DE)
   Stromdichte: 2 A/dm²,
5. Beschichten der Folie mit Trockenfilmresist, belichten, entwickeln in 1 %iger Na₂CO₃-Lösung,
6. Abätzen der Kupfer- und der Nickel/Bor-Schicht:
   Ätzlösung: CuCl₂/HCl mit 120 g/l Cu ges., 3 % HCl, mit Wasser 1 : 1 verdünnt,
7. Abätzen der Palladiumschicht:
   Ätzlösung: HNO₃,konz./HCl,konz. in einer Mischung 3 : 1, mit Wasser 1 : 1 verdünnt,
   Temperatur: Raumtemperatur,
   Behandlungszeit: 15 Sekunden,
8. Trockenfilmresist in Aceton entfernen.

Verfahren 4 (Pattern-Plating-Technik):
- Vorzugsweise Vorbehandeln der Laminatoberflächen und Lochwände mittels Glimmentladung,
- Erzeugen der Grund-Metallschichten durch Zersetzen flüchtiger Metallverbindungen mittels Glimmentladung,
- auf den Grund-Metallschichten stromlos Metall abscheiden, vorzugsweise eine Nickel/Bor-Legierungs- oder Kupferschicht, abgeschieden aus einer sauren oder neutralen Metallisierungslösung,
- Belegen mindestens einer Laminatoberfläche mit Photomasken,
- Belichten und Entwickeln der Photomasken, wobei die Photomasken beim Entwickeln in den Bereichen entfernt werden, in denen Leiterzüge vorgesehen sind und sich die Löcher befinden,
- in den Kanälen und auf den Lochwänden elektrolytisch Metall abscheiden, vorzugsweise Kupfer aus einer sauren Metallisierungslösung, und anschließend eine Metallätzresistschicht, beispielsweise aus Zinn oder einer Zinn/ Blei-Legierung,
- Entfernen der Photomasken,
- Abätzen der stromlos und der ersten elektrolytisch abgeschiedenen Metallschichten zusammen mit den darunter liegenden Grund-Metallschichten.

Beispiel (Semiadditiv-Technik, Pattern-Plating mit stromlos abgeschiedener - Nickel/Bor- oder Kupferschicht):
1. Vorbehandeln eines perforierten Substrats mittels Glimmentladung:
   Gas: Sauerstoff
   Druck: 0,25 hPa,
   Gasfluß: 100 Standard-cm³/min,
   Hochfrequenzleistung: 1000 W,
   Behandlungszeit: 90 Sekunden,
2. Pd-Abscheiden mittels Glimmentladung:
   Metallorganische Verbindung: π-Allyl-π-cyclopentadienyl-Palladium-(II),
   Gas: Ar/O₂ oder N₂/O₂, jeweils in einer Mischung 3 : 1,
   Druck: 0,1 hPa,
   Gasfluß: 25 Standard-cm³/min,
   Verdampfertemperatur: 45 °C,
   Behandlungszeit: 10 - 15 Minuten,
3. Stromlos Nickel/Bor aus einem Nickel/Bor-Bad abscheiden (mit Dimethylaminoboran als Reduktionsmittel):
   Temperatur: 40 °C,
   Behandlungszeit: 2 Minuten,
   alternativ: Kupfer abscheiden aus einem schwach sauren oder neutralen stromlosen Kupferbad (beispielsweise Hypophosphit-Typ),
4. Beschichten der Folie mit Trockenfilmresist, belichten, entwickeln in 1 %iger Na₂CO₃-Lösung,
5. Leiterbahnaufbau mittels elektrolytischer Kupferabscheidung,
6. Metallresistschicht abscheiden (beispielsweise Zinn),
7. Abätzen der Kupfer- und der Nickel/Bor-Schicht:
   Ätzlösung: CuCl₂/HCl mit 120 g/l Cu ges., 3 % HCl, mit Wasser 1 : 1 verdünnt,
8. Abätzen der Palladiumschicht:
   Ätzlösung: HNO₃,konz./HCl,konz. in einer Mischung 3 : 1, mit Wasser 1 : 1 verdünnt,
   Temperatur: Raumtemperatur,
   Behandlungszeit: 1 5 Sekunden,
9. Trockenfilmresist in Aceton entfernen.

Die Haftfestigkeit der erhaltenen Metallschichten auf dem Substrat wird insbesondere durch Wärmebehandlungen nach der Abscheidung dickerer Metallschichten erhöht.

Als Folien ausgebildete, nach dem erfindungsgemäßen Verfahren hergestellte Schaltungsträger können in geeigneten Verfahren zu Stapeln miteinander verklebt werden. Eine doppelseitige oder Vier-Lagen-Schaltung kann auch auf einen starren Träger, beispielsweise eine Keramik- oder FR4-Platte (beispielsweise auch Leiterplatte) oder einen Siliziumträger geklebt werden. Man kann auch zwei, vier oder mehr nach dem erfindungsgemäßen Verfahren hergestellte Mehrlagenschaltungen unter Verwendung einer unbeschichteten Polyimid-Zwischenlage aufeinanderkleben und das erhaltene Zwischenprodukt gegebenenfalls mechanisch bohren und auf herkömmliche Weise naßchemisch durchkontaktieren. Mechanisches Bohren ist erforderlich, weil zum Kleben der einzelnen Lagen benutzter Kleber oder erweichtes Polymer in die in der Glimmentladung gebildeten Löcher gepreßt wird. Die Leiterzüge in den einzelnen Leiterzugebenen werden dann auf herkömmlichem Wege nach dem Bohren von Löchern durch den Stapel hindurch durch chemisches Metallisieren der Lochwände miteinander elektrisch verbunden.

## Patentansprüche

1. Verfahren zur Herstellung elektrischer Schaltungsträger mit feinsten Leiterzügen und für hohe Verdrahtungsdichte aus ein- oder mehrlagigen Laminaten durch Kombination folgender wesentlicher Verfahrensstufen:
- Einbringen von Löchern mit Durchmessern unter 100 µm in die Laminate durch
- Aufbringen einer auf 10 - 100 nm Dicke begrenzten temporären Metallschicht auf mindestens eine Laminatoberfläche,
- Aufbringen eines flüssigen Fotolackes oder Trockenfilmes auf die Metallschicht,
- Strukturieren des Fotolackes oder Trockenfilmes und der Metallschicht mit einer Fotomaskentechnik,
- Ätzen der Löcher in die Metallschicht und das Laminat und
- Entfernen der Metallschicht,
- Bilden von Leiterzugstrukturen und -abständen von unter 100 µm auf mindestens einer Laminatoberfläche und Metallisieren der Lochwände durch
- Abscheiden einer haftfesten ersten Metallschicht mit einer Schichtdicke von 0,01 - 1 µm auf der Laminatoberfläche und den Lochwänden durch Zersetzen flüchtiger Metallverbindungen mittels Glimmentladung,
- Abscheiden weiterer Metallschichten aus sauren bis neutralen Metallisierungsbädern auf der ersten Metallschicht durch stromlose und/oder elektrolytische Metallisierung und
- Strukturierung einzelner Metallschichten mittels einer Fotomaskentechnik.

2. Verfahren nach Anspruch 1, dadurch gekennzeichnet, daß als Fotomaske eine positive Fotolackschicht verwendet wird.

3. Verfahren nach einem der vorstehenden Ansprüche, dadurch gekennzeichnet, daß die Löcher durch ein Vakuumätzverfahren erzeugt werden.

4. Verfahren nach einem der vorstehenden Ansprüche, dadurch gekennzeichnet, daß die Lochwände und Laminatoberflächen vor der Metallisierung mittels Glimmentladung vorbehandelt werden.

5. Verfahren nach einem der vorstehenden Ansprüche, dadurch gekennzeichnet, daß als weitere Metallschicht eine Nickel/Bor-Legierung auf der ersten Metallschicht abgeschieden wird.

6. Verfahren nach einem der vorstehenden Ansprüche, dadurch gekennzeichnet, daß als weitere Metallschicht Kupfer auf der ersten Metallschicht aus einem stromlosen Kupferbad mit Hypophosphit als Reduktionsmittel abgeschieden wird.

7. Verfahren nach einem der vorstehenden Ansprüche, dadurch gekennzeichnet, daß die Leiterzugstrukturen und die Metallschichten auf den Lochwänden im wesentlichen durch stromlose Palladiumabscheidung gebildet werden.

8. Verfahren nach einem der vorstehenden Ansprüche, gekennzeichnet durch eine temporäre Metallschicht aus Aluminium.

9. Verfahren nach einem der vorstehenden Ansprüche, dadurch gekennzeichnet, daß die Schaltungsträger aus aus einem für das Aufbringen von Metallüberzügen geeigneten Nichtleiter bestehenden Folien und/oder Platten gebildet werden, wobei als temporäre Metallschicht eine 10 - 100 nm dicke Aluminium- oder Kupferschicht aufgebracht wird, die von einem 5 - 12 µm dicken Fotolack bedeckt wird.

## Claims

1. Method of producing electrical circuit carriers having very fine conductor tracks and for high wiring density from single- or multiple-ply laminates by combining the following general method steps:
- introducing perforations with diameters less than 100 µm in the laminates by
- applying a temporary metal layer, which has a thickness limited to 10 - 100 nm, to at least one laminate surface,
- applying a liquid photosensitive resist or dry film to the metal layer,
- structuring the photosensitive resist or dry film and the metal layer with a photomasking technique,
- etching the perforations in the metal layer and the laminate, and
- removing the metal layer,
- forming conductor track structures and spacings of less than 100 µm on at least one laminate surface and metallising the walls of the perforations by
- depositing a strongly bonded first metal layer, which has a layer thickness of 0.01 - 1 µm, on the laminate surface and the walls of the perforations by decomposing volatile metal compounds by means of glow discharge,
- depositing additional metal layers from acid to neutral metallisation baths on the first metal layer by electroless and/or electrolytic metallisation, and
- structuring individual metal layers by means of a photomasking technique.

2. Method according to claim 1, characterised in that a positive photosensitive resist layer is employed as the photomask.

3. Method according to one of the preceding claims, characterised in that the perforations are produced by a vacuum etching method.

4. Method according to one of the preceding claims, characterised in that the walls of the perforations and laminate surfaces are pretreated by means of glow discharge prior to the metallisation process.

5. Method according to one of the preceding claims, characterised in that a nickel/boron alloy is deposited as an additional metal layer on the first metal layer.

6. Method according to one of the preceding claims, characterised in that copper is deposited on the first metal layer as an additional metal layer from an electroless copper bath with hypophosphite as the reducing agent.

7. Method according to one of the preceding claims, characterised in that the conductor track structures and the metal layers on the walls of the perforations are substantially formed by electroless palladium deposition.

8. Method according to one of the preceding claims, characterised by a temporary metal layer of aluminium.

9. Method according to one of the preceding claims, characterised in that the circuit carriers are formed from films and/or plates comprising non-conductors suitable for the application of metal coatings, an aluminium or copper layer being applied as a temporary metal layer and having a thickness of 10 - 100 nm, said layer being covered by a photosensitive resist having a thickness of 5 - 12 µm.

## Revendications

1. Procédé de fabrication de supports de circuits électrique avec des conducteurs très fins et pour une densité de câblage élevée à partir de stratifiés monocouche ou multicouche par combinaison des étapes de procédé importantes ci-dessous :
- Introduction de trous avec des diamètres inférieurs à 100 µm dans les stratifiés par
- application d'une couche de métal provisoire limitée à une épaisseur de 10 à 100 nm sur au moins une surface de stratifié,
- application d'une laque photosensible liquide ou d'un film sec sur la couche de métal,
- structuration de la laque photosensible ou du film sec et de la couche de métal avec une technique de photomasque,
- décapage des trous dans la couche de métal et les stratifiés et
- enlèvement de la couche de métal,
- Formation de structures et d'intervalles de conducteur de moins de 100 µm sur au moins une surface de stratifié et métallisation des parois trouées par
- dépôt d'une première couche de métal résistante à l'adhérence avec une épaisseur de couche de 0,01 à 1 µm sur la surface de stratifié et les parois trouées par décomposition de composés métalliques volatils par décharge lumineuse,
- dépôt d'autres couches de métal à partir de bains de métallisation acides à neutres sur la première couche de métal par métallisation sans courant et/ou métallisation électrolytique et
- structuration de couches de métal individuelles au moyen d'une technique de photomasque.

2. Procédé selon la revendication 1, caractérisé en ce qu'on utilise comme photomasque une couche positive de laque photosensible.

3. Procédé selon l'une quelconque des revendications précédentes, caractérisé en ce que les trous sont générés par un procédé de décapage sous vide

4. Procédé selon l'une quelconque des revendications précédentes, caractérisé en ce que les parois trouées et les surfaces de stratifié sont prétraitées avant la métallisation par décharge lumineuse.

5. Procédé selon l'une quelconque des revendications précédentes, caractérisé en ce qu'on dépose comme autre couche de métal un alliage de nickel/bore sur la première couche de métal.

6. Procédé selon l'une quelconque des revendications précédentes, caractérisé en ce qu'on dépose comme autre couche de métal du cuivre sur la première couche de métal à partir d'un bain de cuivre sans courant avec de l'hypophosphite comme agent réducteur.

7. Procédé selon l'une quelconque des revendications précédentes, caractérisé en ce que les structures de conducteur et les couches de métal sur les parois trouées sont formées essentiellement par un dépôt sans courant de palladium.

8. Procédé selon l'une des quelconque des revendications précédentes, caractérisé par une couche de métal provisoire en aluminium.

9. Procédé selon l'une quelconque des revendications précédentes, caractérisé en ce que les supports de circuit sont formés à partir de feuilles à base d'un non-conducteur approprié pour l'application de revêtements métalliques et/ou de plaques, une couche d'aluminium ou de cuivre épaisse de 10 à 100 nm étant appliquée comme couche de métal provisoire, laquelle est recouverte par une laque photosensible épaisse de 5 à 12 µm.
